(19) Europäisches Patentamt / European Patent Office / Office européen des brevets

(11) **EP 3 451 164 B1**

(12) **EUROPEAN PATENT SPECIFICATION**

(45) Date of publication and mention of the grant of the patent:
**14.12.2022 Bulletin 2022/50**

(21) Application number: **16899923.3**

(22) Date of filing: **12.05.2016**

(51) International Patent Classification (IPC):
**H03M 7/24** (2006.01)     **H03M 7/28** (2006.01)
**G06F 9/44** (2018.01)     **G06N 3/02** (2006.01)
**G06F 7/483** (2006.01)

(52) Cooperative Patent Classification (CPC):
**G06N 3/02; G06F 7/483; G06F 9/44; H03M 7/24;**
H03M 7/28

(86) International application number:
**PCT/CN2016/081839**

(87) International publication number:
**WO 2017/185412 (02.11.2017 Gazette 2017/44)**

(54) **NEURAL NETWORK OPERATION DEVICE AND METHOD SUPPORTING FEW-BIT FIXED-POINT NUMBER**

VORRICHTUNG ZUM BETRIEB EINES NEURONALEN NETZWERKS UND VERFAHREN ZUR UNTERSTÜTZUNG EINER FESTKOMMAZAHL VON WENIGEN BITS

DISPOSITIF ET PROCÉDÉ POUR OPÉRATIONS DE RÉSEAU NEURONAL PRENANT EN CHARGE DES NOMBRES À VIRGULE FIXE À PETIT NOMBRE DE BITS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.04.2016 CN 201610282480**

(43) Date of publication of application:
**06.03.2019 Bulletin 2019/10**

(73) Proprietor: **Cambricon (Xi'an) Semiconductor Co., Ltd.**
**Xi'an City, Shaanxi Province (CN)**

(72) Inventors:
• **CHEN, Yunji**
  **Beijing 100191 (CN)**
• **LIU, Shaoli**
  **Beijing 100191 (CN)**
• **GUO, Qi**
  **Beijing 100191 (CN)**
• **CHEN, Tianshi**
  **Beijing 100191 (CN)**

(74) Representative: **AWA Sweden AB**
**Box 5117**
**200 71 Malmö (SE)**

(56) References cited:
**WO-A2-03/104969     CN-A- 101 510 149**
**CN-A- 102 981 854     CN-A- 105 224 284**

• **SUYOG GUPTA ET AL: "Deep Learning with Limited Numerical Precision", ARXIV.ORG, CORNELL UNIVERSITY LIBRARY, 201 OLIN LIBRARY CORNELL UNIVERSITY ITHACA, NY 14853, 9 February 2015 (2015-02-09), XP080677454,**
• **MATTHIEU COURBARIAUX ET AL: "Training deep neural networks with low precision multiplications", CORR (ARXIV), vol. 1412.7024, no. v5, 23 September 2015 (2015-09-23), pages 1-10, XP055566721,**
• **FANG FANG ET AL: "Lightweight Floating-Point Arithmetic: Case Study of Inverse Discrete Cosine Transform", EURASIP JOURNAL ON ADVANCES IN SIGNAL PROCESSING, vol. 2002, no. 9, 1 January 2002 (2002-01-01), pages 879-892, XP055182100, ISSN: 1687-6172, DOI: 10.1155/S1110865702205090**

EP 3 451 164 B1

**Description**

FIELD OF THE INVENTION

The present invention relates to the technical field of artificial neural network operation, in particular, to a device and method for supporting neural network operations with fewer bit of fixed point.

BACKGROUND OF THE INVENTION

Multi-layer artificial neural networks are widely used in the fields of pattern recognition, image processing, function approximation and optimization calculation. Due to high recognition accuracy and good parallelism, multi-layer artificial networks have received more and more attention in the academic and industrial circles in recent years.

Traditional artificial neural network forward propagation process usually stores 32-bit floating point data types for data storage. However, in the forward propagation processes of most artificial neural networks, the same type of data is concentrated in a certain data range. The 32-bit floating point data range can represent far more than the data range of the same type of data. There are a lot of redundant when the 32-bit floating point data type is used, thus increasing the area overhead for hardware. SUYOG GUPTA ET AL: "Deep Learning with Limited Numerical Precision", ARXIV.ORG, CORNELL UNIVERSITY LIBRARY, 201 OLIN LIBRARY CORNELL UNIVERSITY ITHACA, NY 14853, 9 February 2015 (2015-02-09), relates to deep learning with a reduced precision.

OBJECTS AND SUMMARY OF THE INVENTION

In view of this, one purpose of the present invention is to provide a device for performing a forward propagation process of artificial neural network, and another purpose is to provide a method for performing a forward propagation process of artificial neural network, in order to solve at least one of above technical problems.

The invention is defined by the appended claims.

To achieve above purpose, as one aspect of the present invention, the present invention provides a device for performing a forward propagation process of artificial neural network comprising a floating point data statistics module, a data conversion unit and a fixed point data operation module, wherein

the floating point data statistics module is used to perform a statistical analysis on various types of data required for the forward propagation process of artificial neural network to obtain a decimal point location;

the data conversion unit is used to convert the long-bit floating-point data type to the short-bit fixed-point data type according to the decimal point location obtained by the floating point data statistics module;

the floating point data operation module is used to perform an artificial neural network forward propagation process on the short-bit fixed point data after the data conversion unit uses the short-bit fixed point data type to represent all the input, weight, and/or biased data required in the forward propagation process of artificial neural network.

Among those, the floating point data statistics module includes a data extraction unit, a statistical unit, and an analysis unit, wherein the data extracting unit is used for extracting various different types of data in forward propagation process based on the long-bit floating point data, the statistical unit is used to count a data range for the same type of data and a data distribution of each data segment and the analysis unit obtains the decimal point position that should be set for each type of data with a fixed bit fixed point according to the results counted by the statistics unit.

Among those, the device for performing a forward propagation process of artificial neural network further comprises a rounding unit that is used to perform a rounding operation on the data exceeding the short-bit fixed point precision range after the operation is completed.

Among those, the rounding unit is selected from any one of a random rounding unit, a rounding unit, a round up unit, a round down unit, and a round off unit;

wherein the random rounding unit performs the following operations:

$$y = \begin{cases} \lfloor x \rfloor & \text{w.p.} \ 1-\frac{x-\lfloor x \rfloor}{\varepsilon} \\ \lfloor x \rfloor + \varepsilon & \text{w.p.} \ \frac{x-\lfloor x \rfloor}{\varepsilon} \end{cases};$$

wherein y represents the short-bit fixed point data after random rounding, x represents the long-bit floating point data before random rounding, and $\varepsilon$ is the smallest positive integer that the current short-bit fixed point data representation format can represent, i.e. $2^{-\text{Point\_location}}$, $\lfloor x \rfloor$ represents the number of fixed-point data obtained by directly intercepting the original data x; w.p. represents a probability, i.e. when the randomly rounded data y is $\lfloor x \rfloor$ the

probability is $1 - \dfrac{x - \lfloor x \rfloor}{\varepsilon}$ and when it is $\lfloor x \rfloor + \varepsilon$ the probability is $\dfrac{x - \lfloor x \rfloor}{\varepsilon}$ ;

wherein the rounding unit performs the following operations:

$$y = \begin{cases} \lfloor x \rfloor & \text{if } \lfloor x \rfloor \le x \le \lfloor x \rfloor + \frac{\varepsilon}{2} \\ \lfloor x \rfloor + \varepsilon & \text{if } \lfloor x \rfloor + \frac{\varepsilon}{2} \le x \le \lfloor x \rfloor + \varepsilon \end{cases} ;$$

wherein y represents the short-bit fixed point data after rounding, x represents the long-bit floating point data before rounding, and $\varepsilon$ is the smallest positive integer that the current short-bit fixed point data representation format can represent, i.e. $2^{-\text{Point\_location}}$, $\lfloor x \rfloor$ is an integer multiple of $\varepsilon$, of which the value is the maximum number less than or equal to x;

wherein the round up unit performs the following operations:

$$y = \lceil x \rceil ;$$

wherein y represents the short-bit fixed point data after round up, x represents the long-bit floating point data before round up, $\lceil x \rceil$ is an integer multiple of $\varepsilon$, of which the value is the minimum number more than or equal to x; and $\varepsilon$ is the smallest positive integer that the current short-bit fixed point data representation format can represent, i.e. $2^{-\text{Point\_location}}$;

wherein the round down unit performs the following operations:

$$y = \lfloor x \rfloor ;$$

wherein y represents the short-bit fixed point data after round up, x represents the long-bit floating point data before round up, $\lfloor x \rfloor$ is an integer multiple of $\varepsilon$, of which the value is the maximum number less than or equal to x; and $\varepsilon$ is the smallest positive integer that the current short-bit fixed point data representation format can represent, i.e. $2^{-\text{Point\_location}}$;

wherein the round off unit performs the following operations:

$$y = [x];$$

wherein y represents the short-bit fixed point data after round off, x represents the long-bit floating point data before round off, and [x] represents the number obtained by directly rounding off the short-bit fixed point data for the original data x.

Among those, the data conversion unit first rounds the data that is to be processed through the rounding unit, then converts the long-bit floating-point data type to the short-bit fixed-point data type according to the decimal point location obtained by the floating point data statistics module.

Among those, the device for performing a forward propagation process of artificial neural network further comprises an operation cache unit that stores an intermediate operation result of addition and multiplication in the forward propagation process using the long-bit floating point data type.

As another aspect of the present invention, the present invention further provides a method of performing a forward propagation process of artificial neural network comprising steps of:

step 1, obtaining a long-bit floating-point data of each layer of the artificial neural network including weight, bias, and/or input/output values of each layer;

step 2, for the long-bit floating point data obtained, counting a ratio falling in a row of decreasing range [$-2^{X-1-i}$, $2^{X-1-i}$

$-2^{-i}]$ $i = 0,1,...,N$ , wherein X is the total bit of the short-bit fixed point data type; the corresponding ratio obtained is denoted as $p_0, p_1, \ldots, p_N$ , wherein N is a preset positive integer;

step 3, for the long-bit floating point data, setting an overflow rate EPL in advance, and taking the decimal point location as $\max\{i \mid p_i \geq 1 - EPL, i \in \{0,1, \ldots, N\}\}$ ; that is, taking the largest i in 0,1, . . . , $N$, so that $p_i \geq 1 - EPL$ ;

step 4, according to the decimal point location, all the long-bit floating point data are represented by the short-bit fixed point data type;

step 5, performing the forward propagation process of artificial neural network on the short-bit fixed point data.

Among those, in the method of performing a forward propagation process of artificial neural network, a statistical analysis is performed on different layers and different types of data of the artificial neural network to obtain the decimal point location relative to different types of data of the artificial neural network and a calculation is performed respectively.

Among those, in the step of performing the forward propagation process of artificial neural network on the short-bit fixed point data, for addition and multiplication operations in forward propagation processes, the intermediate calculation result is stored in the form of long-bit floating point data.

Among those, after performing the forward propagation process of artificial neural network, the weight and biased data involved in the backward operation employ a copy represented by the long-bit floating point data retained during the forward propagation process, and the rest of the data employs the long-bit floating point data converted by the short-bit fixed point data, and then a backward calculation is performed.

Based on the above technical solution, the operation device and method of the present invention have the following beneficial effects: the forward propagation process in the form of short-bit fixed point can be implemented for multi-layer artificial neural network, thereby greatly reducing the space required to store network parameters, reducing the hardware area overhead, and optimizing the area of the hardware power ratio; the trained neural network model parameter data can be used as a dedicated neural network accelerator and since the short-bit fixed point format is used to represent data, the requirement for the transmission bandwidth of the dedicated neural network accelerator can be reduced, and at the same time, the power consumption caused by the calculation can be reduced.

## BRIEF DESCRIPTION OF FIGURES

Fig. 1 is a specific representation method of the fixed point data structure used for data storage, according to an embodiment of the present invention;

Fig. 2 is a schematic block view of the floating point data statistics module of the device for performing the forward propagation process of artificial neural network, according to an embodiments of the present invention;

Fig. 3 is a schematic block view of the short-bit fixed point calculation part of the forward propagation process module in the device for performing the forward propagation process of artificial neural network, according to an embodiments of the present invention;

Fig. 4 is an example block view of the process of the forward propagation process of neural network, according to an embodiment of the present invention;

Fig. 5 is an example block view of the operation flow of the device for performing the forward propagation process of artificial neural network, according to an embodiment of the present invention;

Fig. 6 is a flow chart of overall implementation for the algorithm according to an embodiment of the present invention.

## DETAILED DESCRIPTION OF THE EMBODIMENTS

In order that the objectives, technical schemes and advantages of the present invention will become more apparent, the present invention will be described in more detail in conjunction with specific embodiments and with reference to the drawings and examples above. Other aspects, advantages, and salient features of the invention will become apparent to those skilled in the art through the following detailed description.

In the present specification, the following various embodiments for describing the principles of the present invention are merely illustrative. The following description with reference to the accompanying drawings is provided to assist in a comprehensive understanding of exemplary embodiments of the invention as defined by the claims. The following description includes various specific details to assist in that understanding but these details are to be regarded as merely exemplary. Accordingly, those of ordinary skill in the art will recognize that various changes and modifications of the embodiments described herein can be made without departing from the invention. In addition, descriptions of well-known functions and constructions are omitted for clarity and conciseness. Moreover, like reference numerals are used for like functions and operations throughout the drawings.

The present invention discloses a device for performing a forward propagation process of neural network comprising a floating point data statistics module, a data conversion unit and a corresponding fixed point data operation module. Among them, the floating point data statistics module is used for statistics and calculations to obtain a suitable fixed point location for storing various types of data in the forward propagation process of the artificial neural network; the data conversion unit is used to convert the long-bit floating-point data type to the short-bit fixed-point data type; the fixed point operation module is used to complete various types of forward propagation process that are required for short bit fixed point data.

Among them, "long-bit floating point data" represents original floating-point data, such as 32-bit floating point data, but it may be a standard 64-bit or 16-bit floating-point number etc., here, only 32 bits are used as a specific embodiment for description; "less-bit fixed point data", also known as "short-bit fixed point data", means that fixed point data is represented by fewer bits than the original floating point data.

The forward propagation process for multi-layer artificial neural network according to the embodiments of the present invention comprises two or more layers of neurons. The short-bit fixed point data type is used to represent all the input, weight, and/or biased data required in the forward propagation process and is used to participate in the operation between layers.

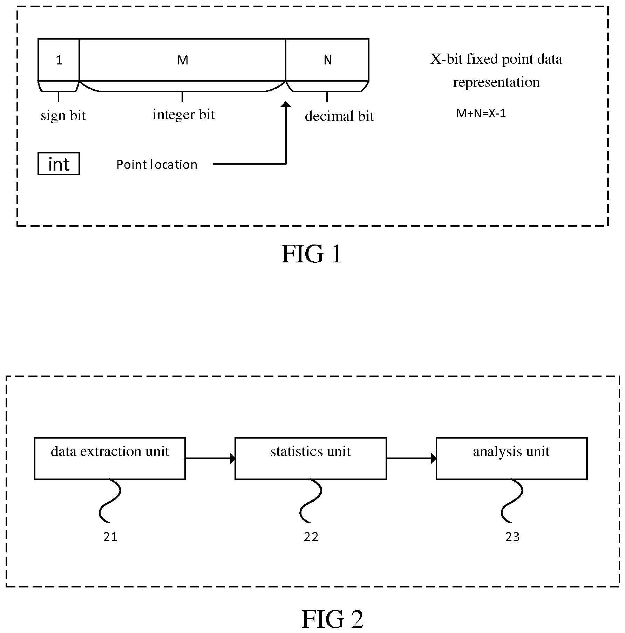

Fig. 1 illustrates a specific representation method of the short-bit fixed point data structure used for data storage, according to embodiments of the present invention. Among them, 1-bit is used to represent signs, M-bit is used to represent integer parts, and N-bit is used to represent fractional parts; compared with the representation form of 32-bit floating point data, in addition to occupying fewer bits, the representation form of short-bit fixed point data sets a symbol bit Point location to record the location of decimal point for the data of a same layer, a same type in the neural network, such as all weight data in the first convolutional layer, for adjusting an accuracy and a representable data range of a data representation according to an actual distribution of data.

Fig. 2 illustrates an example block view of the floating data statistics module. It comprises a data extraction unit 21, a statistical unit 22, and an analysis unit 23. The purpose of this module is that through extracting all 32-bit floating point data in a neural network using the 32-bit floating point data type and analyzing these data to obtain a decimal point location Point location that is used to describe each different type of data in a neural network with short-bit fixed-points, the subsequent forward propagation process of short-bit fixed point results in a better effect. Among those, the data extraction unit is used for extracting various different types of data in the forward training of 32-bit floating point; the statistical unit is used to count a data range for the same type of data and a data distribution of each data segment and the analysis unit obtains the decimal point position that should be set for each type of data with a fixed bit fixed point according to the results counted by the statistics unit.

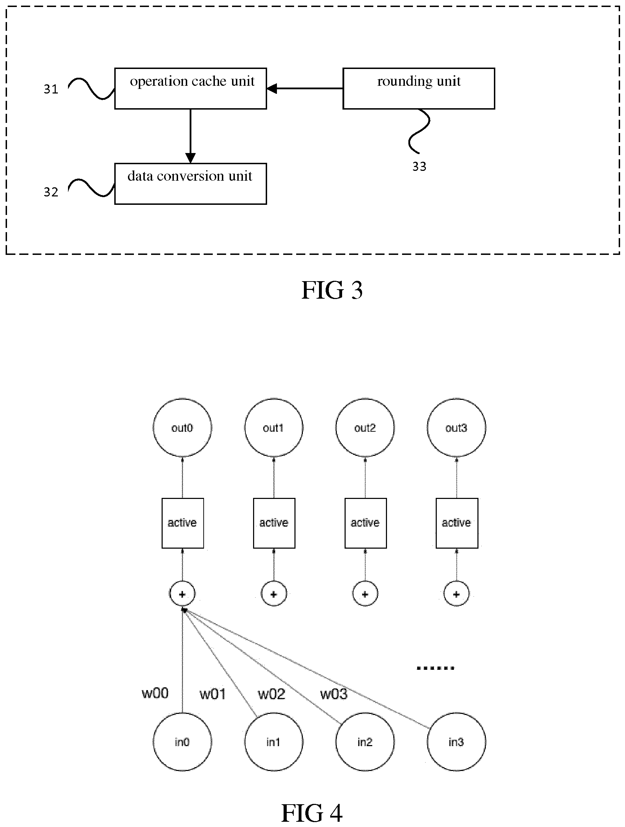

Fig. 3 illustrates an example block view of the short-bit fixed point calculation part of the forward propagation process module. It comprises a cache unit 31, a data conversion unit 32 and a rounding unit 33. Among those: as addition and multiplication operations may cause the data range to expand during the forward propagation process, the cache unit stores an intermediate result of the forward propagation process using the data type with high precision; a rounding operation is performed on the data exceeding the short-bit fixed point precision range after the operation is completed and then the data in cache area is converted to a short-bit fixed point data by the data conversion unit 32.

The rounding unit 33 can perform a rounding operation on the data exceeding the short-bit fixed point precision range. This unit may be a random rounding unit, a rounding unit, a round up unit, a round down unit, and a round off unit. Different rounding units can be used to perform different rounding operations on data beyond the short-bit fixed point precision range.

The random rounding unit performs the following operations:

$$ y = \begin{cases} \lfloor x \rfloor & \text{w.p.} \ \ 1-\frac{x-\lfloor x \rfloor}{\varepsilon} \\ \lfloor x \rfloor + \varepsilon & \text{w.p.} \ \ \frac{x-\lfloor x \rfloor}{\varepsilon} \end{cases} ; $$

wherein $\varepsilon$ is the smallest positive integer that the current short-bit fixed point data representation format can represent, i.e. $2^{-Point\_location}$, $\lfloor x \rfloor$ represents the number of fixed-point data obtained by directly intercepting the original data $x$ (equivalent to performing a round down operation on the decimal); w.p. represents a probability, i.e. when the randomly rounded data $y$ is $\lfloor x \rfloor$ the probability is $1 - \dfrac{x - \lfloor x \rfloor}{\varepsilon}$ and when it is $\lfloor x \rfloor + \varepsilon$ the probability is $\dfrac{x - \lfloor x \rfloor}{\varepsilon}$ .

The rounding unit performs the following operations:

$$y = \begin{cases} \lfloor x \rfloor & \text{if } \lfloor x \rfloor \le x \le \lfloor x \rfloor + \frac{\varepsilon}{2} \\ \lfloor x \rfloor + \varepsilon & \text{if } \lfloor x \rfloor + \frac{\varepsilon}{2} \le x \le \lfloor x \rfloor + \varepsilon \end{cases};$$

wherein y represents the short-bit fixed point data after rounding, x represents the long-bit floating point data before rounding, and $\varepsilon$ is the smallest positive integer that the current short-bit fixed point data representation format can represent, i.e. $2^{-Point\_location}$, $\lfloor x \rfloor$ is an integer multiple of $\varepsilon$, of which the value is the maximum number less than or equal to x.

The round up unit performs the following operations:

$$y = \lceil x \rceil;$$

wherein y represents the short-bit fixed point data after round up, x represents the long-bit floating point data before round up, $\lceil x \rceil$ is an integer multiple of $\varepsilon$, of which the value is the minimum number more than or equal to x; and $\varepsilon$ is the smallest positive integer that the current short-bit fixed point data representation format can represent, i.e. $2^{-Point\_location}$.

The round down unit performs the following operations:

$$y = \lfloor x \rfloor;$$

wherein y represents the short-bit fixed point data after round up, x represents the long-bit floating point data before round up, $\lfloor x \rfloor$ is an integer multiple of $\varepsilon$, of which the value is the maximum number less than or equal to x; and $\varepsilon$ is the smallest positive integer that the current short-bit fixed point data representation format can represent, i.e. $2^{-Point\_location}$.

The round off unit performs the following operations:

$$y = [x];$$

wherein y represents the short-bit fixed point data after round off, x represents the long-bit floating point data before round off, and [x] represents the number obtained by directly rounding off the short-bit fixed point data for the original data *x*.

The present invention further discloses a method of performing a forward propagation process of artificial neural network comprising specific steps of:

The 32-bit floating point model data of each layer of the neural network is obtained through a trained 32-bit floating point model of the neural network, including the weights, biased data, input and output values, and other data parameters of each layer.

For different layers and for the data of each type, counting a ratio falling in a row of decreasing range $\left[ -2^{X-1-i}, 2^{X-1-i} - 2^{-i} \right]$ $i = 0,1,\ldots, N$ ( X is the total bit of the short-bit fixed point data type); the corresponding ratio obtained is denoted as $p_0, p_1, \ldots, p_N$ , wherein N is a preset positive integer;

For the data of each type, pre-setting an overflow rate EPL in advance, and taking the decimal point location as max{$i \mid p_i \ge 1 - EPL$, $i \in \{0,1,\ldots,N\}$}; that is, taking the largest i in 0,1, . . . , $N$ , so that $p_i \ge 1 - EPL$ ;

according to the decimal point location, all the long-bit floating point data are represented by the short-bit fixed point data type.

The short-bit fixed point representation obtained by statistics is used for forward propagation process of the neural network, that is, all data in the forward propagation processes of the neural network is represented by a short-bit fixed point format, and at the same time, a copy represented by 32-bit floating point data is reserved for the weight and biased data of the neural network, and then a forward training is performed. For forward propagation processes, some operations will cause the data range to expand, such as addition, multiplication, and so on. It is necessary to use the cache space to store the intermediate calculation results, which are stored in 32-bit floating point format and after calculation returned to the corresponding short-bit fixed point format. The process of converting 32-bit float point to short-bit fixed point requires rounding, which includes random rounding, round rounding, etc. that are expressed as follows: The random rounding unit performs the following operations:

$$y = \begin{cases} \lfloor x \rfloor & \text{w.p. } 1 - \frac{x - \lfloor x \rfloor}{\varepsilon} \\ \lfloor x \rfloor + \varepsilon & \text{w.p. } \frac{x - \lfloor x \rfloor}{\varepsilon} \end{cases};$$

wherein $\varepsilon$ is the smallest positive integer that the current short-bit fixed point data representation format can represent, i.e. $2^{-Point\_location}$, $\lfloor x \rfloor$ represents the number of fixed-point data obtained by directly intercepting the original data $x$ (equivalent to performing a round down operation on the decimal); w.p. represents a probability, i.e. when the randomly rounded data $y$ is $\lfloor x \rfloor$ the probability is $1 - \frac{x - \lfloor x \rfloor}{\varepsilon}$ and when it is $\lfloor x \rfloor + \varepsilon$ the probability is $\frac{x - \lfloor x \rfloor}{\varepsilon}$.

The rounding unit performs the following operations:

$$y = \begin{cases} \lfloor x \rfloor & \text{if } \lfloor x \rfloor \leq x \leq \lfloor x \rfloor + \frac{\varepsilon}{2} \\ \lfloor x \rfloor + \varepsilon & \text{if } \lfloor x \rfloor + \frac{\varepsilon}{2} \leq x \leq \lfloor x \rfloor + \varepsilon \end{cases};$$

wherein y represents the short-bit fixed point data after rounding, x represents the long-bit floating point data before rounding, and $\varepsilon$ is the smallest positive integer that the current short-bit fixed point data representation format can represent, i.e. $2^{-Point\_location}$, $\lfloor x \rfloor$ is an integer multiple of $\varepsilon$, of which the value is the maximum number less than or equal to x.

The round up unit performs the following operations:

$$y = \lceil x \rceil;$$

wherein y represents the short-bit fixed point data after round up, x represents the long-bit floating point data before round up, $\lceil x \rceil$ is an integer multiple of $\varepsilon$, of which the value is the minimum number more than or equal to x; and $\varepsilon$ is the smallest positive integer that the current short-bit fixed point data representation format can represent, i.e. $2^{-Point\_location}$.

The round down unit performs the following operations:

$$y = \lfloor x \rfloor;$$

wherein y represents the short-bit fixed point data after round up, x represents the long-bit floating point data before round up, $\lfloor x \rfloor$ is an integer multiple of $\varepsilon$, of which the value is the maximum number less than or equal to x; and $\varepsilon$ is the smallest positive integer that the current short-bit fixed point data representation format can represent, i.e. $2^{-Point\_location}$.

The round off unit performs the following operations:

$$y = [x];$$

wherein y represents the short-bit fixed point data after round off, x represents the long-bit floating point data before round off, and [x] represents the number obtained by directly rounding off the short-bit fixed point data for the original data $x$.

After the forward propagation process is completed, when the backward operation is performed, the data in the forward propagation process has to be converted into the 32-bit floating point to participate in the backward operation through the data conversion unit converting the short-bit fixed point to the 32-bit floating point, wherein the weights and biased data involved in the backward operation uses a copy of the 32-bit floating point data retained in the forward propagation process. After the end of the backward operation, the subsequent operation is performed after the data conversion unit converting the 32-bit floating point to short-bit fixed point data. At the same time, a copy of the 32-bit fixed point data representation is still reserved for the weight and biased data of the neural network. The rounding operation has to be performed during the conversion process, and the operation is the same as the rounding operation in the forward propagation process.

The forward and backward operations as described above are repeated until the neural network training is completed.

Fig. 4 is a flow chart of the process of the forward propagation process of single-layer artificial neural network, according to an embodiment of the present invention. The flow chart describes the process of achieving a forward propagation process for single-layer artificial neural network using the device and instruction set of the present invention. For each layer, an intermediate result vector of the layer is first calculated by weighted summation of the input neuron vector. The intermediate result vector is biased and activated to obtain an output neuron vector. The output neuron vector is the input neuron vector of the next layer.

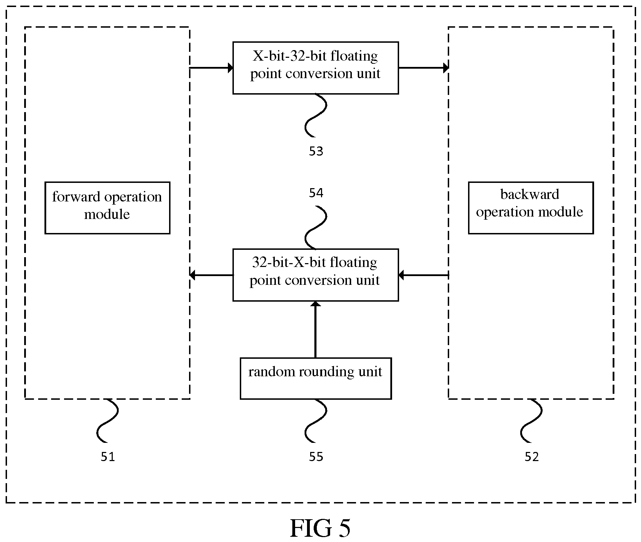

Fig. 5 is an example block view of the operation flow according to an embodiment of the present invention; Among them, the forward propagation process module 51 includes the short-digit fixed point calculation module shown in FIG. 3. The parameters other than weight and biased data obtained by the forward propagation process must first be converted to a 32-bit floating point through the X-32-bit floating point conversion unit 53 for a backward propagation operation before backward propagation, and have to be converted to a short-bit fixed-point data through the 32-bit floating point-X-bit conversion unit 54 after the backward operation module 53 performing the backward propagation operation. During the conversion process, a rounding operation shown in Fig. 3 should be performed on the data exceeding the short-bit fixed point precision range by the random rounding unit 55.

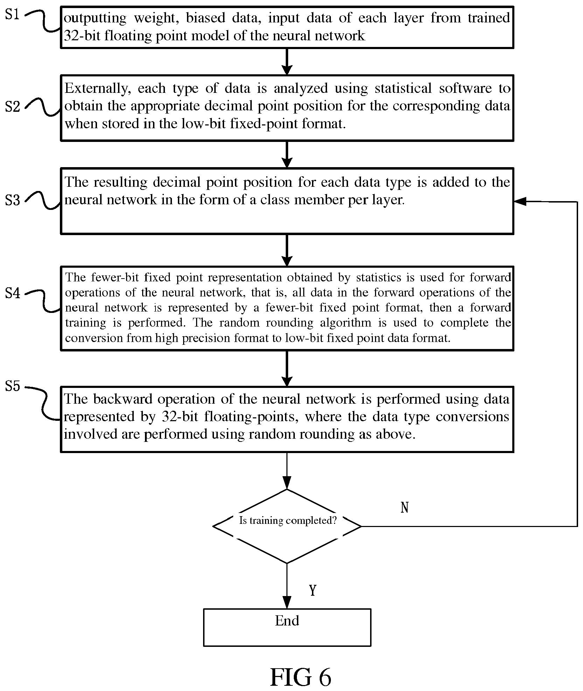

Fig. 6 illustrates a flow chart of overall implementation for the algorithm according to embodiments of the present invention. Details of operations have been given in the description of Fig. 1 to Fig. 5 , and detailed steps and specific implementation steps in the content of the invention are completely the same and will not be described herein.

Through the use of short-bit fixed point representations of data for forward propagation processes, the data range space of short-bit fixed point data format is fully utilized. Compared with 32-bit floating point data representation, the space required for storage of network parameters is greatly reduced and the area-to-power ratio of the hardware is optimized.

Processes or methods depicted in the preceding figures may be implemented by the processing logic including hardware (eg, circuitry, dedicated logic, etc.), firmware, software (eg, software carried on a non-transitory computer readable medium) or the combination thereof to perform. Although the processes or methods are described above in terms of certain sequential operations, it should be understood that some of the described operations can be performed in a different order. In addition, some operations may be performed in parallel rather than sequentially.

In the foregoing specification, various embodiments of the present invention have been described with reference to specific exemplary embodiments thereof. Obviously, various modifications may be made to the embodiments without departing from the invention as set forth in the appended claims. Accordingly, the specification and drawings are to be regarded in an illustrative rather than a restrictive sense.

**Claims**

1. A device for performing a forward propagation process of an artificial neural network, the device comprising a floating point data statistics module, a data conversion unit (32) and a fixed point data operation module, wherein

   the floating point data statistics module is used to perform a statistical analysis on various types of data required for the forward propagation process of the artificial neural network to obtain a decimal point location;
   wherein the floating point data statistics module includes a data extraction unit (21), a statistical unit (22), and an analysis unit (23), wherein
   the data extracting unit (21) is configured to extract the various types of data in the forward propagation process based on a long-bit floating point data,
   the statistical unit (22) is configured to count a data range for a same type of data and a data distribution of each data segment, wherein the same type of data is concentrated in the data range, and
   the analysis unit (23) is configured to obtain the decimal point location that should be set for each type of data with a fixed bit fixed point according to the results counted by the statistics unit;
   the data conversion unit (32) is used to convert a long-bit floating-point data type to a short-bit fixed-point data type according to the decimal point location obtained by the floating point data statistics module;
   the fixed point data operation module is used to perform an artificial neural network forward propagation process on the short-bit fixed point data after the data conversion unit using the short-bit fixed point data type to represent all the input, weight, and/or biased data required in the forward propagation process of artificial neural network;

wherein the long-bit floating point data is original floating point data, the short-bit fixed point data means that the short-bit fixed point data is represented by fewer bits than the original floating point data; wherein a short-bit fixed point data structure for storing the short-bit fixed point data comprises:

one bit for storing a sign of the short-bit fixed point data,
M bits for storing an integer part of the short-bit fixed point data, and
N bits for storing a fractional part of the short-bit fixed point data;
wherein a representation form of the short-bit fixed point data sets a symbol bit Point location to record the decimal point location for data of a same layer, a same type in the artificial neural network, for adjusting an accuracy and a representable data range of a data representation according to the data distribution.

2. The device according to claim 1,
wherein the short-bit fixed point data is weight data of a first convolutional layer of the artificial neural network.

3. The device for performing a forward propagation process of artificial neural network according to claim 1, **characterized by** further comprising a rounding unit (33) used to perform a rounding operation on a data exceeding the short-bit fixed point precision range after the operation is completed.

4. The device for performing a forward propagation process of artificial neural network according to claim 3, **characterized in that** the rounding unit (33) is selected from any one of a random rounding unit, a rounding unit, a round up unit, a round down unit, and a round off unit;

wherein the random rounding unit performs the following operations:

$$
y = \begin{cases} \lfloor x \rfloor & w.p.\ 1 - \dfrac{x - \lfloor x \rfloor}{\varepsilon} \\ \lfloor x \rfloor + \varepsilon & w.p.\ \dfrac{x - \lfloor x \rfloor}{\varepsilon} \end{cases}
$$

wherein y represents the short-bit fixed point data after random rounding, x represents the long-bit floating point data before random rounding, and $\varepsilon$ is the smallest positive integer that the current short-bit fixed point data representation format can represent, i.e. $2^{-Point\_location}$, $\lfloor x \rfloor$ is an integer multiple of $\varepsilon$, of which the value is the maximum number less than or equal to x; w.p. represents a probability, i.e. when the randomly rounded data

y is $\lfloor x \rfloor$ the probability is $1 - \dfrac{x - \lfloor x \rfloor}{\varepsilon}$ and when it is $\lfloor x \rfloor + \varepsilon$ the probability is $\dfrac{x - \lfloor x \rfloor}{\varepsilon}$ ;
wherein the rounding unit performs the following operations:

$$
y = \begin{cases} \lfloor x \rfloor & \text{if } \lfloor x \rfloor \le x \le \lfloor x \rfloor + \dfrac{\varepsilon}{2} \\ \lfloor x \rfloor + \varepsilon & \text{if } \lfloor x \rfloor + \dfrac{\varepsilon}{2} \le x \le \lfloor x \rfloor + \varepsilon \end{cases} ;
$$

wherein y represents the short-bit fixed point data after rounding, X represents the long-bit floating point data before rounding, and $\varepsilon$ is the smallest positive integer that the current short-bit fixed point data representation format can represent, i.e. $2^{-Point\_location}$, $\lfloor x \rfloor$ is an integer multiple of $\varepsilon$, of which the value is the maximum number less than or equal to X;
wherein the round up unit performs the following operations:

$$
y = \lceil x \rceil ;
$$

wherein y represents the short-bit fixed point data after round up, x represents the long-bit floating point data before round up, $\lceil x \rceil$ is an integer multiple of $\varepsilon$, of which the value is the minimum number more than or equal

to x; and $\varepsilon$ is the smallest positive integer that the current short-bit fixed point data representation format can represent, i.e. $2^{-\text{Point\_location}}$;

wherein the round down unit performs the following operations:

$$y = \lfloor x \rfloor;$$

wherein y represents the short-bit fixed point data after round down, x represents the long-bit floating point data before round up, $\lceil x \rceil$ is an integer multiple of $\varepsilon$, of which the value is the maximum number less than or equal to x; and $\varepsilon$ is the smallest positive integer that the current short-bit fixed point data representation format can represent, i.e. $2^{-\text{Point\_location}}$;

wherein the round off unit performs the following operations:

$$y = [x];$$

wherein y represents the short-bit fixed point data after round off, x represents the long-bit floating point data before round off, and [x] represents the number obtained by directly rounding off the short-bit fixed point data for the original data x.

5. The device for performing a forward propagation process of artificial neural network according to claim 3, **characterized in that** the data conversion unit (32) first rounds the data to be processed through the rounding unit, then converts the long-bit floating-point data type to the short-bit fixed-point data type according to the decimal point location obtained by the floating point data statistics module.

6. The device for performing a forward propagation process of artificial neural network according to claim 1, **characterized by** further comprising an operation cache unit (31) for storing an intermediate operation result of addition and multiplication in the forward propagation process using the long-bit floating point data type.

7. A method of performing a forward propagation process of an artificial neural network, the method comprising:

   a floating point data statistics module performing a statistical analysis on various types of data required for the forward propagation process of the artificial neural network to obtain a decimal point location;
   a data conversion unit (32) converting a long-bit floating-point data type to a short-bit fixed-point data type according to the decimal point location obtained by the floating point data statistics module;
   a fixed point data operation module performing an artificial neural network forward propagation process on the short-bit fixed point data after the data conversion unit using the short-bit fixed point data type to represent all the input, weight, and/or biased data required in the forward propagation process of artificial neural network;
   wherein the floating point data statistics module includes a data extraction unit (21), a statistical unit (22), and an analysis unit (23);
   wherein the method comprises:

   the data extracting unit (21) extracting the various types of data in the forward propagation process based on a long-bit floating point data,
   the statistical unit (22) counting a data range for a same type of data and a data distribution of each data segment, wherein the same type of data is concentrated in the data range, and
   the analysis unit (23) obtaining the decimal point location that should be set for each type of data with a fixed bit fixed point according to the results counted by the statistics unit;
   wherein the long-bit floating point data is original floating point data, the short-bit fixed point data means that the short-bit fixed point data is represented by fewer bits than the original floating point data;
   wherein a short-bit fixed point data structure for storing the short-bit fixed point data comprises:

   one bit for storing a sign of the short-bit fixed point data,
   M bits for storing an integer part of the short-bit fixed point data, and
   N bits for storing a fractional part of the short-bit fixed point data;

   wherein a representation form of the short-bit fixed point data sets a symbol bit Point location to record the decimal point location for data of a same layer, a same type in the artificial neural network, for adjusting an accuracy and a representable data range of a data representation according to the data distribution.

**8.** The method according to claim 7,
wherein the short-bit fixed point data is weight data of a first convolutional layer of the artificial neural network.

**9.** The method according to claim 7, further comprising
a rounding unit (33) performing a rounding operation on a data exceeding the short-bit fixed point precision range after the operation is completed.

**10.** The method according to claim 9, wherein the rounding unit (33) is selected from any one of a random rounding unit, a rounding unit, a round up unit, a round down unit, and a round off unit;

wherein the random rounding unit performs the following operations:

$$y = \begin{cases} \lfloor x \rfloor & w.p.\ 1 - \dfrac{x - \lfloor x \rfloor}{\varepsilon} \\ \lfloor x \rfloor + \varepsilon & w.p.\ \dfrac{x - \lfloor x \rfloor}{\varepsilon} \end{cases}$$

wherein y represents the short-bit fixed point data after random rounding, x represents the long-bit floating point data before random rounding, and $\varepsilon$ is the smallest positive integer that the current short-bit fixed point data representation format can represent, i.e. $2^{-Point\_location}$, $\lfloor x \rfloor$ is an integer multiple of $\varepsilon$, of which the value is the maximum number less than or equal to x; w.p. represents a probability, i.e. when the randomly rounded data y is $\lfloor x \rfloor$ the probability is $1 - \dfrac{x - \lfloor x \rfloor}{\varepsilon}$ and when it is $\lfloor x \rfloor + \varepsilon$ the probability is $\dfrac{x - \lfloor x \rfloor}{\varepsilon}$ ;

wherein the rounding unit performs the following operations:

$$y = \begin{cases} \lfloor x \rfloor & \text{if } \lfloor x \rfloor \le x \le \lfloor x \rfloor + \dfrac{\varepsilon}{2} \\ \lfloor x \rfloor + \varepsilon & \text{if } \lfloor x \rfloor + \dfrac{\varepsilon}{2} \le x \le \lfloor x \rfloor + \varepsilon \end{cases} ;$$

wherein y represents the short-bit fixed point data after rounding, X represents the long-bit floating point data before rounding, and $\varepsilon$ is the smallest positive integer that the current short-bit fixed point data representation format can represent, i.e. $2^{-Point\_location}$, $\lfloor x \rfloor$ is an integer multiple of $\varepsilon$, of which the value is the maximum number less than or equal to X;
wherein the round up unit performs the following operations:

$$y = \lceil x \rceil ;$$

wherein y represents the short-bit fixed point data after round up, x represents the long-bit floating point data before round up, $\lceil x \rceil$ is an integer multiple of $\varepsilon$, of which the value is the minimum number more than or equal to x; and $\varepsilon$ is the smallest positive integer that the current short-bit fixed point data representation format can represent, i.e. $2^{-Point\_location}$;
wherein the round down unit performs the following operations:

$$y = \lfloor x \rfloor ;$$

wherein y represents the short-bit fixed point data after round down, x represents the long-bit floating point data before round up, $\lceil x \rceil$ is an integer multiple of $\varepsilon$, of which the value is the maximum number less than or equal to x; and $\varepsilon$ is the smallest positive integer that the current short-bit fixed point data representation format can represent, i.e. $2^{-Point\_location}$;

wherein the round off unit performs the following operations:

$$y = [x]_;$$

wherein y represents the short-bit fixed point data after round off, x represents the long-bit floating point data before round off, and [x] represents the number obtained by directly rounding off the short-bit fixed point data for the original data x.

**11.** The method according to claim 9, wherein the data conversion unit (32) first rounds the data to be processed through the rounding unit, then converts the long-bit floating-point data type to the short-bit fixed-point data type according to the decimal point location obtained by the floating point data statistics module.

**12.** The method according to claim 7, further comprising
an operation cache unit (31) storing an intermediate operation result of addition and multiplication in the forward propagation process using the long-bit floating point data type.

**13.** The method according to any one of the claims 7-12, comprising steps of:

step 1, by using the data extraction unit (21) of the floating point data statistics module, obtaining a long-bit floating-point data of each layer of the artificial neural network including weight, bias, and/or input/output values of each layer;

step 2, by using the statistical unit (22) of the floating point data statistics module, for the long-bit floating point data obtained, counting a ratio falling in a row of decreasing range $\left[ -2^{X-1-i}, 2^{X-1-i} - 2^{-i} \right]$ $i=0,1,...,N$, wherein X is the total bit of the short-bit fixed point data type; the corresponding ratio obtained is denoted as $p_0, p_1, \ldots, p_N$, wherein N is a preset positive integer;

step 3, for the long-bit floating point data, setting, by using the analysis unit (23) of the floating point data statistics module, an overflow rate EPL in advance, and taking the decimal point location as max$\{i \mid p_i \geq 1 - EPL, i \in \{0,1, \ldots, N\}\}$; that is, taking the largest i in $0,1,...,N$, so that $p_i \geq 1 - EPL$;

step 4, according to the decimal point location, all the long-bit floating point data are represented by the short-bit fixed point data type by using the data conversion unit;

step 5, performing, by using the fixed point data operation module, the forward propagation process of artificial neural network on the short-bit fixed point data.

**14.** The method according to claim 13, further comprising
performing a statistical analysis, by using the floating point data statistics module, on different layers and different types of data of the artificial neural network to obtain the decimal point location relative to different types of data of the artificial neural network and a calculation is performed respectively.

**15.** The method according to claim 13, **characterized in that** in the step of performing the forward propagation process of artificial neural network on the short-bit fixed point data, for addition and multiplication operations in forward propagation process, the intermediate calculation result is stored in the form of long-bit floating point data.

**16.** The method according to claim 13, wherein after performing the forward propagation process of the artificial neural network, the weight and biased data involved in the backward operation employ a copy represented by the long-bit floating point data retained during the forward propagation process, and the rest of the data employs the long-bit floating point data converted by the short-bit fixed point data, and then a backward calculation is performed.

**Patentansprüche**

**1.** Vorrichtung zum Durchführen eines Vorwärtspropagationsprozesses eines künstlichen neuronalen Netzes, wobei die Vorrichtung ein Gleitkommadatenstatistikmodul, eine Datenkonvertierungseinheit (32) und ein Gleitkommadatenoperationsmodul umfasst, wobei

das Gleitkommadatenstatistikmodul verwendet wird, um eine statistische Analyse an verschiedenen Typen von Daten durchzuführen, die für den Vorwärtspropagationsprozess des künstlichen neuronalen Netzes benötigt werden, um eine Dezimalkommaposition zu erhalten;

wobei das Gleitkommadatenstatistikmodul eine Datenextraktionseinheit (21), eine Statistikeinheit (22) und eine Analyseeinheit (23) umfasst, wobei die Datenextraktionseinheit (21) dafür konfiguriert ist, die verschiedenen Typen von Daten in dem Vorwärtspropagationsprozess auf der Grundlage von Langbit-Gleitkommadaten zu extrahieren,

die Statistikeinheit (22) dafür konfiguriert ist, einen Datenbereich für einen selben Typ von Daten und eine Datenverteilung jedes Datensegments zu zählen, wobei derselbe Typ von Daten in dem Datenbereich konzentriert ist, und

die Analyseeinheit (23) dafür konfiguriert ist, die Dezimalkommaposition, die für jeden Typ von Daten mit einem Festbit-Festkomma festzulegen ist, gemäß den durch die Statistikeinheit gezählten Ergebnissen zu erhalten;

wobei die Datenkonvertierungseinheit (32) dafür verwendet wird, einen Langbit-Gleitkomma-Datentyp gemäß der durch das Gleitkommadatenstatistikmodul erhaltenen Dezimalkommaposition in einen Kurzbit-Festkomma-Datentyp zu konvertieren;

das Festkommadatenoperationsmodul dafür verwendet wird, einen Vorwärtspropagationsprozess eines künstlichen neuronalen Netzes an den Kurzbit-Festkommadaten nach der Datenkonvertierungseinheit durchzuführen, wobei der Kurzbit-Festkomma-Datentyp dafür verwendet wird, alle Eingabe-, Gewichts- und/oder verzerrten Daten darzustellen, die in dem Vorwärtspropagationsprozess des künstlichen neuronalen Netzes benötigt werden;

wobei die Langbit-Gleitkommadaten ursprüngliche Gleitkommadaten sind, wobei die Kurzbit-Festkommadaten bedeuten, dass die Kurzbit-Festkommadaten durch weniger Bits als die ursprünglichen Gleitkommadaten dargestellt werden;

wobei eine Kurzbit-Festkomma-Datenstruktur zum Speichern der Kurzbit-Festkommadaten umfasst:

ein Bit zum Speichern eines Vorzeichens der Kurzbit-Festkommadaten,
M Bits zum Speichern eines ganzzahligen Teils der Kurzbit-Festkommadaten, und
N Bits zum Speichern eines Bruchteils der Kurzbit-Festkommadaten;

wobei eine Darstellungsform der Kurzbit-Festkommadaten eine Symbolbit-Kommaposition festlegt, um die Dezimalkommaposition für Daten einer selben Schicht, eines selben Typs in dem künstlichen neuronalen Netz, aufzuzeichnen, um eine Genauigkeit und einen darstellbaren Datenbereich einer Datendarstellung gemäß der Datenverteilung einzustellen.

2. Vorrichtung nach Anspruch 1,
wobei die Kurzbit-Festkommadaten Gewichtsdaten einer ersten Faltungsschicht des künstlichen neuronalen Netzes sind.

3. Vorrichtung zum Durchführen eines Vorwärtspropagationsprozesses eines künstlichen neuronalen Netzes nach Anspruch 1, **dadurch gekennzeichnet, dass** sie des Weiteren eine Rundungseinheit (33) umfasst, die dafür verwendet wird, eine Rundungsoperation an Daten, die den Kurzbit-Festkommapräzisionsbereich überschreiten, durchzuführen, nachdem die Operation abgeschlossen ist.

4. Vorrichtung zum Durchführen eines Vorwärtspropagationsprozesses eines künstlichen neuronalen Netzes nach Anspruch 3, **dadurch gekennzeichnet, dass** die Rundungseinheit (33) aus einer Zufallsrundungseinheit, einer Rundungseinheit, einer Aufrundungseinheit, einer Abrundungseinheit und einer Auf-/Abrundungseinheit ausgewählt ist; wobei die Zufallsrundungseinheit die folgenden Operationen durchführt:

$$y = \begin{cases} \lfloor x \rfloor & w.p.\ 1 - \dfrac{x - \lfloor x \rfloor}{\varepsilon} \\[2mm] \lfloor x \rfloor + \varepsilon & w.p.\ \dfrac{x - \lfloor x \rfloor}{\varepsilon} \end{cases}$$

wobei y die Kurzbit-Festkommadaten nach der Zufallsrundung darstellt, x die Langbit-Gleitkommadaten vor der Zufallsrundung darstellt, und $\varepsilon$ die kleinste positive ganze Zahl ist, die das momentane Kurzbit-Festkommadaten-Darstellungsformat darstellen kann, das heißt $2^{-Komma\_position}$, $\lfloor x \rfloor$ ein ganzzahliges Vielfaches von $\varepsilon$ ist, dessen Wert die maximale Zahl kleiner oder gleich x ist; w.p. eine Wahrscheinlichkeit darstellt, das heißt, wenn die zufallsgerundeten Daten y gleich $\lfloor x \rfloor$ sind, so ist die Wahrscheinlichkeit $1 - \dfrac{x - \lfloor x \rfloor}{\varepsilon}$, und wenn sie $\lfloor x \rfloor + \varepsilon$ sind, so ist die Wahrscheinlichkeit $\dfrac{x - \lfloor x \rfloor}{\varepsilon}$;

wobei die Rundungseinheit die folgenden Operationen durchführt:

$$y = \begin{cases} \lfloor x \rfloor & falls \;\; \lfloor x \rfloor \leq x \leq \lfloor x \rfloor + \dfrac{\varepsilon}{2} \\[2ex] \lfloor x \rfloor + \varepsilon & falls \;\; \lfloor x \rfloor + \dfrac{\varepsilon}{2} \leq x \leq \lfloor x \rfloor + \varepsilon \end{cases}$$

wobei y die Kurzbit-Festkommadaten nach dem Runden darstellt, x die Langbit-Gleitkommadaten vor dem Runden darstellt, und $\varepsilon$ die kleinste positive ganze Zahl ist, die das momentane Kurzbit-Festkommadaten-Darstellungsformat darstellen kann, das heißt $2^{-Komma\_position}$, $\lfloor x \rfloor$ ein ganzzahliges Vielfaches von $\varepsilon$ ist, dessen Wert die maximale Zahl kleiner oder gleich x ist;

wobei die Aufrundungseinheit die folgenden Operationen durchführt:

$$y = \lceil x \rceil;$$

wobei y die Kurzbit-Festkommadaten nach dem Aufrunden darstellt, x die Langbit-Gleitkommadaten vor dem Aufrunden darstellt, $\lceil x \rceil$ ein ganzzahliges Vielfaches von $\varepsilon$ ist, dessen Wert die kleinste Zahl größer oder gleich x ist; und $\varepsilon$ die kleinste positive ganze Zahl ist, die das momentane Kurzbit-Festkommadaten-Darstellungsformat darstellen kann, das heißt $2^{-Komma\_position}$;

wobei die Abrundungseinheit die folgenden Operationen durchführt:

$$y = \lfloor x \rfloor;$$

wobei y die Kurzbit-Festkommadaten nach dem Abrunden darstellt, x die Langbit-Gleitkommadaten vor dem Aufrunden darstellt, $\lfloor x \rfloor$ ein ganzzahliges Vielfaches von $\varepsilon$ ist, dessen Wert die größte Zahl kleiner oder gleich x ist; und $\varepsilon$ die kleinste positive ganze Zahl ist, die das momentane Kurzbit-Festkommadaten-Darstellungsformat darstellen kann, das heißt $2^{-Komma\_position}$;

wobei die Auf-/Abrundungseinheit die folgenden Operationen durchführt:

$$y = [x];$$

wobei y die Kurzbit-Festkommadaten nach dem Auf-/Abrunden darstellt, x die Langbit-Gleitkommadaten vor dem Auf-/Abrunden darstellt, und [x] die Zahl darstellt, die durch direktes Auf-/Abrunden der Kurzbit-Festkommadaten für die ursprünglichen Daten x erhalten wird.

5. Vorrichtung zum Durchführen eines Vorwärtspropagationsprozesses eines künstlichen neuronalen Netzes nach Anspruch 3, **dadurch gekennzeichnet, dass** die Datenkonvertierungseinheit (32) zuerst die zu verarbeitenden Daten durch die Rundungseinheit rundet und dann den Langbit-Gleitkomma-Datentyp gemäß der durch das Gleitkommadatenstatistikmodul erhaltenen Dezimalkommaposition in den Kurzbit-Festkomma-Datentyp konvertiert.

6. Vorrichtung zum Durchführen eines Vorwärtspropagationsprozesses eines künstlichen neuronalen Netzes nach Anspruch 1, **dadurch gekennzeichnet, dass** sie des Weiteren eine Operations-Cache-Einheit (31) umfasst, um ein Zwischenoperationsergebnis einer Addition und Multiplikation in dem Vorwärtspropagationsprozess unter Verwendung des Langbit-Gleitkomma-Datentyps zu speichern.

**7.** Verfahren zum Durchführen eines Vorwärtspropagationsprozesses eines künstlichen neuronalen Netzes, wobei das Verfahren umfasst, dass:

ein Gleitkommadatenstatistikmodul eine statistische Analyse an verschiedenen Typen von Daten durchführt, die für den Vorwärtspropagationsprozess des künstlichen neuronalen Netzes benötigt werden, um eine Dezimalkommaposition zu erhalten;

die Datenkonvertierungseinheit (32) einen Langbit-Gleitkomma-Datentyp gemäß der durch das Gleitkommadatenstatistikmodul erhaltenen Dezimalkommaposition in einen Kurzbit-Festkomma-Datentyp konvertiert;

ein Festkommadatenoperationsmodul einen Vorwärtspropagationsprozess eines künstlichen neuronalen Netzes an den Kurzbit-Festkommadaten nach der Datenkonvertierungseinheit durchführt, wobei der Kurzbit-Festkomma-Datentyp dafür verwendet wird, alle Eingabe-, Gewichts- und/oder verzerrten Daten darzustellen, die in dem Vorwärtspropagationsprozess des künstlichen neuronalen Netzes benötigt werden;

wobei das Gleitkommadatenstatistikmodul eine Datenextraktionseinheit (21), eine Statistikeinheit (22) und eine Analyseeinheit (23) umfasst;

wobei das Verarbeiten umfasst, dass:

die Datenextraktionseinheit (21) die verschiedenen Typen von Daten in dem Vorwärtspropagationsprozess auf der Grundlage von Langbit-Gleitkommadaten extrahiert,

die Statistikeinheit (22) einen Datenbereich für einen selben Typ von Daten und eine Datenverteilung jedes Datensegments zählt, wobei derselbe Typ von Daten in dem Datenbereich konzentriert ist, und

die Analyseeinheit (23) die Dezimalkommaposition, die für jeden Typ von Daten mit einem Festbit-Festkomma festzulegen ist, gemäß den durch die Statistikeinheit gezählten Ergebnissen erhält;

wobei die Langbit-Gleitkommadaten ursprüngliche Gleitkommadaten sind, wobei die Kurzbit-Festkommadaten bedeuten, dass die Kurzbit-Festkommadaten durch weniger Bits als die ursprünglichen Gleitkommadaten dargestellt werden;

wobei eine Kurzbit-Festkomma-Datenstruktur zum Speichern der Kurzbit-Festkommadaten umfasst:

ein Bit zum Speichern eines Vorzeichens der Kurzbit-Festkommadaten,
M Bits zum Speichern eines ganzzahligen Teils der Kurzbit-Festkommadaten, und
N Bits zum Speichern eines Bruchteils der Kurzbit-Festkommadaten;

wobei eine Darstellungsform der Kurzbit-Festkommadaten eine Symbolbit-Kommaposition festlegt, um die Dezimalkommaposition für Daten einer selben Schicht, eines selben Typs in dem künstlichen neuronalen Netz, aufzuzeichnen, um eine Genauigkeit und einen darstellbaren Datenbereich einer Datendarstellung gemäß der Datenverteilung einzustellen.

**8.** Verfahren nach Anspruch 7, wobei die Kurzbit-Festkommadaten Gewichtsdaten einer ersten Faltungsschicht des künstlichen neuronalen Netzes sind.

**9.** Verfahren nach Anspruch 7, das des Weiteren umfasst, dass eine Rundungseinheit (33) eine Rundungsoperation an den Daten, die den Kurzbit-Festkommapräzisionsbereich überschreiten, durchführt, nachdem die Operation abgeschlossen ist.

**10.** Verfahren nach Anspruch 9, wobei die Rundungseinheit (33) aus einer Zufallsrundungseinheit, einer Rundungseinheit, einer Aufrundungseinheit, einer Abrundungseinheit und einer Auf-/Abrundungseinheit ausgewählt wird; wobei die Zufallsrundungseinheit die folgenden Operationen durchführt:

$$
y = \begin{cases} \lfloor x \rfloor & w.p.\ 1 - \dfrac{x - \lfloor x \rfloor}{\varepsilon} \\[2ex] \lfloor x \rfloor + \varepsilon & w.p.\ \dfrac{x - \lfloor x \rfloor}{\varepsilon} \end{cases}
$$

wobei y die Kurzbit-Festkommadaten nach der Zufallsrundung darstellt, x die Langbit-Gleitkommadaten vor der Zufallsrundung darstellt, und ε die kleinste positive ganze Zahl ist, die das momentane Kurzbit-Festkommadaten-Darstellungsformat darstellen kann, das heißt $2^{-Komma\_position}$, $\lfloor x \rfloor$ ein ganzzahliges Vielfaches von $\varepsilon$ ist, dessen Wert die maximale Zahl kleiner oder gleich x ist; w.p. eine Wahrscheinlichkeit darstellt, das heißt, wenn die zufallsgerundeten Daten y gleich $\lfloor x \rfloor$ sind, so ist die Wahrscheinlichkeit $\frac{x-\lfloor x \rfloor}{\varepsilon}$ ,, und wenn sie $\lfloor x \rfloor + \varepsilon$ sind, so ist die Wahrscheinlichkeit $\frac{x-\lfloor x \rfloor}{\varepsilon}$ ;

wobei die Rundungseinheit die folgenden Operationen durchführt:

$$y = \begin{cases} \lfloor x \rfloor & falls \ \lfloor x \rfloor \le x \le \lfloor x \rfloor + \dfrac{\varepsilon}{2} \\ \lfloor x \rfloor + \varepsilon & falls \ \lfloor x \rfloor + \dfrac{\varepsilon}{2} \le x \le \lfloor x \rfloor + \varepsilon \end{cases}$$

wobei y die Kurzbit-Festkommadaten nach dem Runden darstellt, x die Langbit-Gleitkommadaten vor dem Runden darstellt, und $\varepsilon$ die kleinste positive ganze Zahl ist, die das momentane Kurzbit-Festkommadaten-Darstellungsformat darstellen kann, das heißt $2^{-Komma\_position}$, $\lfloor x \rfloor$ ein ganzzahliges Vielfaches von $\varepsilon$ ist, dessen Wert die maximale Zahl kleiner oder gleich x ist;
wobei die Aufrundungseinheit die folgenden Operationen durchführt:

$$y = \lceil x \rceil;$$

wobei y die Kurzbit-Festkommadaten nach dem Aufrunden darstellt, x die Langbit-Gleitkommadaten vor dem Aufrunden darstellt, $\lceil x \rceil$ ein ganzzahliges Vielfaches von $\varepsilon$ ist, dessen Wert die kleinste Zahl größer oder gleich x ist; und $\varepsilon$ die kleinste positive ganze Zahl ist, die das momentane Kurzbit-Festkommadaten-Darstellungsformat darstellen kann, das heißt $2^{-Komma\_position}$;
wobei die Abrundungseinheit die folgenden Operationen durchführt:

$$y = \lfloor x \rfloor;$$

wobei y die Kurzbit-Festkommadaten nach dem Abrunden darstellt, x die Langbit-Gleitkommadaten vor dem Aufrunden darstellt, $\lfloor x \rfloor$ ein ganzzahliges Vielfaches von $\varepsilon$ ist, dessen Wert die größte Zahl kleiner oder gleich x ist; und $\varepsilon$ die kleinste positive ganze Zahl ist, die das momentane Kurzbit-Festkommadaten-Darstellungsformat darstellen kann, das heißt $2^{-Komma\_position}$;
wobei die Auf-/Abrundungseinheit die folgenden Operationen durchführt:

$$y = [x];$$

wobei y die Kurzbit-Festkommadaten nach dem Auf-/Abrunden darstellt, x die Langbit-Gleitkommadaten vor dem Auf-/Abrunden darstellt, und [x] die Zahl darstellt, die durch direktes Auf-/Abrunden der Kurzbit-Festkommadaten für die ursprünglichen Daten x erhalten wird.

11. Verfahren nach Anspruch 9, wobei die Datenkonvertierungseinheit (32) zuerst die zu verarbeitenden Daten durch die Rundungseinheit rundet und dann den Langbit-Gleitkomma-Datentyp gemäß der durch das Gleitkommadatenstatistikmodul erhaltenen Dezimalkommaposition in den Kurzbit-Festkomma-Datentyp konvertiert.

12. Verfahren nach Anspruch 7, das des Weiteren umfasst,
dass eine Operations-Cache-Einheit (31) ein Zwischenoperationsergebnis der Addition und Multiplikation in dem Vorwärtspropagationsprozess unter Verwendung des Langbit-Gleitkommadatentyps speichert.

**13.** Verfahren nach einem der Ansprüche 7 bis 12, das die folgenden Schritte umfasst:

Schritt 1: unter Verwendung der Datenextraktionseinheit (21) des Gleitkommadatenstatistikmoduls, Erhalten von Langbit-Gleitkommadaten jeder Schicht des künstlichen neuronalen Netzes, einschließlich Gewichts-, Verzerrungs- und/oder Eingabe-/Ausgabewerten jeder Schicht;

Schritt 2: unter Verwendung der Statistikeinheit (22) des Gleitkommadatenstatistikmoduls, für die erhaltenen Langbit-Gleitkommadaten, Zählen eines Verhältnisses, das in eine Reihe mit abnehmendem Bereich $[-2^{X-1-i}, 2^{X-1-i} - 2^{-i}]$ fällt, i = 0, 1, ..., N, wobei X das Gesamtbit des Kurzbit-Festkomma-Datentyps ist; wobei das entsprechende erhaltene Verhältnis als $p_0$, $p_1$, ..., $p_N$ bezeichnet wird, wobei N eine voreingestellte positive ganze Zahl ist;

Schritt 3: für die Langbit-Gleitkommadaten, Einstellen, unter Verwendung der Analyseeinheit (23) des Gleitkommadatenstatistikmoduls, einer Überlaufrate EPL im Voraus. und Nehmen der Dezimalkommaposition als $\max\{i \mid p_i \geq 1 - EPL, i \in \{0, 1, ..., N\}\}$; das heißt, Nehmen des größten i in 0, 1, ..., N, so dass $p_i \geq 1 - EPL$;

Schritt 4: gemäß der Dezimalkommaposition werden alle Langbit-Gleitkommadaten durch den Kurzbit-Festkomma-Datentyp unter Verwendung der Datenkonvertierungseinheit dargestellt;

Schritt 5: Durchführen, unter Verwendung des Festkommadatenoperationsmoduls, des Vorwärtspropagationsprozesses eines künstlichen neuronalen Netzes an den Kurzbit-Festkommadaten.

**14.** Verfahren nach Anspruch 13, das des Weiteren umfasst:
Durchführen einer statistischen Analyse, unter Verwendung des Gleitkommadatenstatistikmoduls, an verschiedenen Schichten und verschiedenen Typen von Daten des künstlichen neuronalen Netzes, um die Dezimalkommaposition relativ zu verschiedenen Typen von Daten des künstlichen neuronalen Netzes zu erhalten, wobei jeweils eine Berechnung durchgeführt wird.

**15.** Verfahren nach Anspruch 13, **dadurch gekennzeichnet, dass** in dem Schritt des Durchführens des Vorwärtspropagationsprozesses des künstlichen neuronalen Netzes an den Kurzbit-Festkommadaten für Additions- und Multiplikationsoperationen in dem Vorwärtspropagationsprozess das Zwischenberechnungsergebnis in Form von Langbit-Gleitkommadaten gespeichert wird.

**16.** Verfahren nach Anspruch 13, wobei nach dem Durchführen des Vorwärtspropagationsprozesses des künstlichen neuronalen Netzes die Gewichts- und verzerrten Daten, die an der Rückwärtsoperation beteiligt sind, eine Kopie verwenden, die durch die Langbit-Gleitkommadaten dargestellt wird, die während des Vorwärtspropagationsprozesses beibehalten wurden, und der Rest der Daten die Langbit-Gleitkommadaten verwendet, die durch die Kurzbit-Festkommadaten konvertiert werden, und dann eine Rückwärtsberechnung durchgeführt wird.

**Revendications**

**1.** Dispositif de réalisation d'un processus de propagation vers l'avant d'un réseau neuronal artificiel, le dispositif comprenant un module de statistiques de données en virgule flottante, une unité de conversion de données (32) et un module d'opération de données en virgule fixe, dans lequel

le module de statistiques de données en virgule flottante est utilisé pour réaliser une analyse statistique sur divers types de données nécessaires au processus de propagation vers l'avant du réseau neuronal artificiel pour obtenir un emplacement de virgule décimale ;

dans lequel le module de statistiques de données en virgule flottante inclut une unité d'extraction de données (21), une unité de statistiques (22), et une unité d'analyse (23), dans lequel

l'unité d'extraction de données (21) est configurée pour extraire les divers types de données dans le processus de propagation vers l'avant sur la base de données en virgule flottante à grand nombre de bits,

l'unité de statistiques (22) est configurée pour compter une plage de données pour un même type de données et une distribution de données de chaque segment de données, dans lequel le même type de données est concentré dans la plage de données, et

l'unité d'analyse (23) est configurée pour obtenir l'emplacement de virgule décimale qui doit être réglé pour chaque type de données avec une virgule fixe à nombre fixe de bits en fonction des résultats comptés par l'unité de statistiques ;

l'unité de conversion de données (32) est utilisée pour convertir un type de données en virgule flottante à grand nombre de bits en un type de données en virgule fixe à petit nombre de bits en fonction de l'emplacement de virgule décimale obtenu par le module de statistiques de données en virgule flottante ;

le module d'opération de données en virgule fixe est utilisé pour réaliser un processus de propagation vers l'avant de réseau neuronal artificiel sur les données en virgule fixe à petit nombre de bits après que l'unité de conversion de données utilise le type de données en virgule fixe à petit nombre de bits pour représenter toutes les données d'entrée, de poids et/ou de biais nécessaires dans le processus de propagation vers l'avant du réseau neuronal artificiel ;

dans lequel les données en virgule flottante à grand nombre de bits sont des données en virgule flottante initiales, les données en virgule fixe à petit nombre de bits signifient que les données en virgule fixe à petit nombre de bits sont représentées par moins de bits que les données en virgule flottante initiales ;

dans lequel une structure de données en virgule fixe à petit nombre de bits pour stocker les données en virgule fixe à petit nombre de bits comprend :

un bit pour stocker un signe des données en virgule fixe à petit nombre de bits,
M bits pour stocker une partie entière des données en virgule fixe à petit nombre de bits, et
N bits pour stocker une partie fractionnelle des données en virgule fixe à petit nombre de bits ;

dans lequel une forme de représentation des données en virgule fixe à petit nombre de bits règle un emplacement de virgule à bits de symbole pour enregistrer l'emplacement de virgule décimale pour des données d'une même couche, d'un même type dans le réseau neuronal artificiel, pour ajuster une précision et une plage de données représentable d'une représentation de données en fonction de la distribution de données.

**2.** Dispositif selon la revendication 1,
dans lequel les données en virgule fixe à petit nombre de bits sont des données de poids d'une première couche de convolution du réseau neuronal artificiel.

**3.** Dispositif de réalisation d'un processus de propagation vers l'avant de réseau neuronal artificiel selon la revendication 1, **caractérisé en ce qu'**il comprend en outre une unité d'arrondissement (33) utilisée pour réaliser une opération d'arrondissement sur des données dépassant la plage de précision de virgule fixe à petit nombre de bits après que l'opération est effectuée.

**4.** Dispositif de réalisation d'un processus de propagation vers l'avant de réseau neuronal artificiel selon la revendication 3, **caractérisé en ce que** l'unité d'arrondissement (33) est sélectionnée parmi une unité d'arrondissement aléatoire, une unité d'arrondissement, une unité d'arrondissement supérieur, une unité d'arrondissement inférieur, et une unité d'arrondissement complet ;

dans lequel l'unité d'arrondissement aléatoire réalise les opérations suivantes :

$$y = \begin{cases} \lfloor x \rfloor & w.p.\ 1 - \dfrac{x - \lfloor x \rfloor}{\varepsilon} \\ \lfloor x \rfloor + \varepsilon & w.p.\ \dfrac{x - \lfloor x \rfloor}{\varepsilon} \end{cases}$$

où y représente les données en virgule fixe à petit nombre de bits après un arrondissement aléatoire, x représente les données en virgule flottante à grand nombre de bits avant un arrondissement aléatoire, et $\varepsilon$ est le plus petit entier positif que le format courant de représentation de données en virgule fixe à petit nombre de bits peut représenter, c'est-à-dire $2^{-Point\_location}$, $\lfloor x \rfloor$ est un multiple entier de $\varepsilon$, dont la valeur est le nombre maximal inférieur ou égal à x ; w.p. représente une probabilité, c'est-à-dire que, lorsque les données ayant subi un arrondissement aléatoire y sont $\lfloor x \rfloor$, la probabilité est $1 - \dfrac{x-\lfloor x \rfloor}{\varepsilon}$ et, lorsqu'elles sont $\lfloor x \rfloor + \varepsilon$, la probabilité est $\dfrac{x-\lfloor x \rfloor}{\varepsilon}$ ;

dans lequel l'unité d'arrondissement réalise les opérations suivantes :

$$y = \begin{cases} \lfloor x \rfloor & si \; \lfloor x \rfloor \leq x \leq \lfloor x \rfloor + \dfrac{\varepsilon}{2} \\ \lfloor x \rfloor + \varepsilon & si \; \lfloor x \rfloor + \dfrac{\varepsilon}{2} \leq x \leq \lfloor x \rfloor + \varepsilon \end{cases}$$

où y représente les données en virgule fixe à petit nombre de bits après un arrondissement, x représente les données en virgule flottante à grand nombre de bits avant un arrondissement, et $\varepsilon$ est le plus petit entier positif que le format courant de représentation de données en virgule fixe à petit nombre de bits peut représenter, c'est-à-dire $2^{-Point\_location}$, $\lfloor x \rfloor$ est un multiple entier de $\varepsilon$, dont la valeur est le nombre maximal inférieur ou égal à x ; dans lequel l'unité d'arrondissement supérieur réalise les opérations suivantes :

$$y = \lceil x \rceil$$

où y représente les données en virgule fixe à petit nombre de bits après un arrondissement supérieur, x représente les données en virgule flottante à grand nombre de bits avant un arrondissement supérieur, $\lceil x \rceil$ est un multiple entier de $\varepsilon$ dont la valeur est le nombre minimal supérieur ou égal à x ; et $\varepsilon$ est le plus petit entier positif que le format courant de représentation de données en virgule fixe à petit nombre de bits peut représenter, c'est-à-dire $2^{-Point\_location}$ ;
dans lequel l'unité d'arrondissement inférieur réalise les opérations suivantes :

$$y = \lfloor x \rfloor$$

où y représente les données en virgule fixe à petit nombre de bits après un arrondissement inférieur, x représente les données en virgule flottante à grand nombre de bits avant un arrondissement inférieur, $\lfloor x \rfloor$ est un multiple entier de $\varepsilon$ dont la valeur est le nombre maximal inférieur ou égal à x ; et $\varepsilon$ est le plus petit entier positif que le format courant de représentation de données en virgule fixe à petit nombre de bits peut représenter, c'est-à-dire $2^{-Point\_location}$ ;
dans lequel l'unité d'arrondissement complet réalise les opérations suivantes :

$$y = [x]$$

où y représente les données en virgule fixe à petit nombre de bits après un arrondissement complet, x représente les données en virgule flottante à grand nombre de bits avant un arrondissement complet, et [x] représente le nombre obtenu par l'arrondissement complet direct des données en virgule fixe à petit nombre de bits pour les données initiales x.

5. Dispositif de réalisation d'un processus de propagation vers l'avant de réseau neuronal artificiel selon la revendication 3, **caractérisé en ce que** l'unité de conversion de données (32) arrondit d'abord les données à traiter par l'intermédiaire de l'unité d'arrondissement, puis convertit le type de données en virgule flottante à grand nombre de bits dans le type de données en virgule fixe à petit nombre de bits en fonction de l'emplacement de virgule décimale obtenu par le module de statistiques de données en virgule flottante.

6. Dispositif de réalisation d'un processus de propagation vers l'avant de réseau neuronal artificiel selon la revendication 1, **caractérisé en ce qu'**il comprend en outre une unité de cache d'opération (31) pour stocker un résultat d'opération intermédiaire d'addition et de multiplication dans le processus de propagation vers l'avant en utilisant le type de données en virgule flottante à grand nombre de bits.

7. Procédé de réalisation d'un processus de propagation vers l'avant d'un réseau neuronal artificiel, le procédé comprenant :

par un module de statistiques de données en virgule flottante, la réalisation d'une analyse statistique sur divers types de données nécessaires au processus de propagation vers l'avant du réseau neuronal artificiel pour obtenir un emplacement de virgule décimale ;
par une unité de conversion de données (32), la conversion d'un type de données en virgule flottante à grand nombre de bits en un type de données en virgule fixe à petit nombre de bits en fonction de l'emplacement de virgule décimale obtenu par le module de statistiques de données en virgule flottante ;

par un module d'opération de données en virgule fixe, la réalisation d'un processus de propagation vers l'avant de réseau neuronal artificiel sur les données en virgule fixe à petit nombre de bits après que l'unité de conversion de données utilise le type de données en virgule fixe à petit nombre de bits pour représenter toutes les données d'entrée, de poids et/ou de biais nécessaires dans le processus de propagation vers l'avant du réseau neuronal artificiel ;

dans lequel le module de statistiques de données en virgule flottante inclut une unité d'extraction de données (21), une unité de statistiques (22), et une unité d'analyse (23) ;

dans lequel le procédé comprend :

par l'unité d'extraction de données (21), l'extraction des divers types de données dans le processus de propagation vers l'avant sur la base de données en virgule flottante à grand nombre de bits,

par l'unité de statistiques (22), le comptage d'une plage de données pour un même type de données et une distribution de données de chaque segment de données, dans lequel le même type de données est concentré dans la plage de données, et

par l'unité d'analyse (23), l'obtention de l'emplacement de virgule décimale qui doit être réglé pour chaque type de données avec une virgule fixe à nombre fixe de bits en fonction des résultats comptés par l'unité de statistiques ;

dans lequel les données en virgule flottante à grand nombre de bits sont des données en virgule flottante initiales, les données en virgule fixe à petit nombre de bits signifient que les données en virgule fixe à petit nombre de bits sont représentées par moins de bits que les données en virgule flottante initiales ;

dans lequel une structure de données en virgule fixe à petit nombre de bits pour stocker les données en virgule fixe à petit nombre de bits comprend :

un bit pour stocker un signe des données en virgule fixe à petit nombre de bits,
M bits pour stocker une partie entière des données en virgule fixe à petit nombre de bits, et
N bits pour stocker une partie fractionnelle des données en virgule fixe à petit nombre de bits ;

dans lequel une forme de représentation des données en virgule fixe à petit nombre de bits règle un emplacement de virgule à bits de symbole pour enregistrer l'emplacement de virgule décimale pour des données d'une même couche, d'un même type dans le réseau neuronal artificiel, pour ajuster une précision et une plage de données représentable d'une représentation de données en fonction de la distribution de données.

8. Procédé selon la revendication 7,
dans lequel les données en virgule fixe à petit nombre de bits sont des données de poids d'une première couche de convolution du réseau neuronal artificiel.

9. Procédé selon la revendication 7, comprenant en outre
par une unité d'arrondissement (33), la réalisation d'une opération d'arrondissement sur des données dépassant la plage de précision de virgule fixe à petit nombre de bits après que l'opération est effectuée.

10. Procédé selon la revendication 9, dans lequel l'unité d'arrondissement (33) est sélectionnée parmi une unité d'arrondissement aléatoire, une unité d'arrondissement, une unité d'arrondissement supérieur, une unité d'arrondissement inférieur, et une unité d'arrondissement complet ;

dans lequel l'unité d'arrondissement aléatoire réalise les opérations suivantes :

$$y = \begin{cases} \lfloor x \rfloor & w.p.\ 1 - \dfrac{x - \lfloor x \rfloor}{\varepsilon} \\ \lfloor x \rfloor + \varepsilon & w.p.\ \dfrac{x - \lfloor x \rfloor}{\varepsilon} \end{cases}$$

où y représente les données en virgule fixe à petit nombre de bits après un arrondissement aléatoire, x représente les données en virgule flottante à grand nombre de bits avant un arrondissement aléatoire, et $\varepsilon$ est le plus petit entier positif que le format courant de représentation de données en virgule fixe à petit nombre de bits peut représenter, c'est-à-dire $2^{-Point\_location}$, $\lceil x \rceil$ est un multiple entier de $\varepsilon$, dont la valeur est le nombre maximal inférieur ou égal à x ; w.p. représente une probabilité, c'est-à-dire que, lorsque les données ayant subi un arrondissement aléatoire y sont $\lfloor x \rfloor$, la probabilité est $1 - \frac{x - \lfloor x \rfloor}{\varepsilon}$ et, lorsqu'elles sont $\lfloor x \rfloor + \varepsilon$, la probabilité est $\frac{x - \lfloor x \rfloor}{\varepsilon}$ ;

dans lequel l'unité d'arrondissement réalise les opérations suivantes :

$$y = \begin{cases} \lfloor x \rfloor & si \ \lfloor x \rfloor \leq x \leq \lfloor x \rfloor + \dfrac{\varepsilon}{2} \\ \lfloor x \rfloor + \varepsilon & si \ \lfloor x \rfloor + \dfrac{\varepsilon}{2} \leq x \leq \lfloor x \rfloor + \varepsilon \end{cases}$$

où y représente les données en virgule fixe à petit nombre de bits après un arrondissement, x représente les données en virgule flottante à grand nombre de bits avant un arrondissement, et $\varepsilon$ est le plus petit entier positif que le format courant de représentation de données en virgule fixe à petit nombre de bits peut représenter, c'est-à-dire $2^{-Point\_location}$, $\lfloor x \rfloor$ est un multiple entier de $\varepsilon$, dont la valeur est le nombre maximal inférieur ou égal à x ; dans lequel l'unité d'arrondissement supérieur réalise les opérations suivantes :

$$y = \lceil x \rceil$$

où y représente les données en virgule fixe à petit nombre de bits après un arrondissement supérieur, x représente les données en virgule flottante à grand nombre de bits avant un arrondissement supérieur, $\lceil x \rceil$ est un multiple entier de $\varepsilon$ dont la valeur est le nombre minimal supérieur ou égal à x ; et $\varepsilon$ est le plus petit entier positif que le format courant de représentation de données en virgule fixe à petit nombre de bits peut représenter, c'est-à-dire $2^{-Point\_location}$ ;
dans lequel l'unité d'arrondissement inférieur réalise les opérations suivantes :

$$y = \lfloor x \rfloor$$

où y représente les données en virgule fixe à petit nombre de bits après un arrondissement inférieur, x représente les données en virgule flottante à grand nombre de bits avant un arrondissement inférieur, $\lfloor x \rfloor$ est un multiple entier de $\varepsilon$ dont la valeur est le nombre maximal inférieur ou égal à x ; et $\varepsilon$ est le plus petit entier positif que le format courant de représentation de données en virgule fixe à petit nombre de bits peut représenter, c'est-à-dire $2^{-Point\_location}$ ;
dans lequel l'unité d'arrondissement complet réalise les opérations suivantes :

$$y = [x]$$

où y représente les données en virgule fixe à petit nombre de bits après un arrondissement complet, x représente les données en virgule flottante à grand nombre de bits avant un arrondissement complet, et [x] représente le nombre obtenu par l'arrondissement complet direct des données en virgule fixe à petit nombre de bits pour les données initiales x.

11. Procédé selon la revendication 9, dans lequel l'unité de conversion de données (32) arrondit d'abord les données à traiter par l'intermédiaire de l'unité d'arrondissement, puis convertit le type de données en virgule flottante à grand nombre de bits dans le type de données en virgule fixe à petit nombre de bits en fonction de l'emplacement de virgule décimale obtenu par le module de statistiques de données en virgule flottante.

12. Procédé selon la revendication 7, comprenant en outre :
par une unité de cache d'opération (31), le stockage d'un résultat d'opération intermédiaire d'addition et de multiplication dans le processus de propagation vers l'avant en utilisant le type de données en virgule flottante à grand nombre de bits.

13. Procédé selon l'une quelconque des revendications 7 à 12, comprenant les étapes suivantes :

étape 1, par l'utilisation de l'unité d'extraction de données (21) du module de statistiques de données en virgule flottante, l'obtention de données en virgule flottante à grand nombre de bits de chaque couche du réseau neuronal artificiel incluant des valeurs de poids, de biais et/ou d'entrée/sortie de chaque couche ;

étape 2, par l'utilisation de l'unité de statistiques (22) du module de statistiques de données en virgule flottante, pour les données en virgule flottante à grand nombre de bits obtenues, le comptage d'un rapport tombant dans une rangée de plage décroissante $[-2^{x-1-i}, 2^{x-1-i}-2^{-i}]$ i = 0, 1, ..., N, où X est le nombre total de bits du type de données en virgule fixe à petit nombre de bits ; le rapport correspondant est représenté par $p_0$, $p_1$, ..., $p_N$, où N est un entier positif préréglé ;

étape 3, pour les données en virgule flottante à grand nombre de bits, le réglage, par l'utilisation de l'unité d'analyse (23) du module de statistiques de données en virgule flottante, d'un taux de débordement EPL à l'avance, et en prenant l'emplacement de virgule décimale

en tant que $max\{i|p_i \geq 1 - EPL, i \in \{0,1, ...,N\}\}$ ; c'est-à-dire en prenant le plus grand i parmi 0, 1, ..., N, de sorte que $p_i \geq 1 - EPL$ ;

étape 4, en fonction de l'emplacement de virgule décimale, toutes les données en virgule décimale à grand nombre de bits sont représentées par le type de données en virgule fixe à petit nombre de données par l'utilisation de l'unité de conversion de données ;

étape 5, la réalisation, par l'utilisation du module d'opération de données en virgule fixe, du processus de propagation vers l'avant du réseau neuronal artificiel sur les données en virgule fixe à petit nombre de bits.

14. Procédé selon la revendication 13, comprenant en outre
la réalisation d'une analyse statistique, par l'utilisation du module de statistiques de données en virgule flottante, sur différentes couches et différents types de données du réseau neuronal artificiel pour obtenir l'emplacement de virgule flottante par rapport à différents types de données du réseau neuronal artificiel et un calcul est respectivement réalisé.

15. Procédé selon la revendication 13, **caractérisé en ce que**, à l'étape de la réalisation du processus de propagation vers l'avant du réseau neuronal artificiel sur les données en virgule fixe à petit nombre de données, pour des opérations d'addition et de multiplication dans le processus de propagation vers l'avant, le résultat de calcul intermédiaire est stocké sous la forme de données en virgule flottante à grand nombre de bits.

16. Procédé selon la revendication 13, dans lequel, après la réalisation du processus de propagation vers l'avant du réseau neuronal artificiel, les données de poids et de biais impliquées dans l'opération vers l'arrière emploient une copie représentée par les données en virgule flottante à grand nombre de bits conservées pendant le processus de propagation vers l'avant, et le reste des donnés emploie les données en virgule flottante à grand nombre de bits converties par les données en virgule fixe à petit nombre de bits, puis un calcul vers l'arrière est réalisé.

| 1 | M | N |
|---|---|---|

sign bit  integer bit  decimal bit

X-bit fixed point data representation

$M+N=X-1$

int  Point location

## FIG 1

| data extraction unit | statistics unit | analysis unit |
|---|---|---|

21  22  23

## FIG 2

FIG 3

FIG 4

FIG 5

S1 — outputting weight, biased data, input data of each layer from trained 32-bit floating point model of the neural network

S2 — Externally, each type of data is analyzed using statistical software to obtain the appropriate decimal point position for the corresponding data when stored in the low-bit fixed-point format.

S3 — The resulting decimal point position for each data type is added to the neural network in the form of a class member per layer.

S4 — The fewer-bit fixed point representation obtained by statistics is used for forward operations of the neural network, that is, all data in the forward operations of the neural network is represented by a fewer-bit fixed point format, then a forward training is performed. The random rounding algorithm is used to complete the conversion from high precision format to low-bit fixed point data format.

S5 — The backward operation of the neural network is performed using data represented by 32-bit floating-points, where the data type conversions involved are performed using random rounding as above.

Is training completed?

N

Y

End

FIG 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **SUYOG GUPTA et al.** Deep Learning with Limited Numerical Precision. *ARXIV.ORG, CORNELL UNIVERSITY LIBRARY, 201 OLIN LIBRARY CORNELL UNIVERSITY ITHACA, NY 14853,* 09 February 2015